Europäisches Patentamt

(19) European Patent Office

Office européen des brevets

(11) Publication number: **0 096 155**
**B1**

(12) **EUROPEAN PATENT SPECIFICATION**

(45) Date of publication of patent specification: **16.12.87**

(51) Int. Cl.⁴: **H 01 L 21/285,** H 01 L 29/08

(21) Application number: **83101750.4**

(22) Date of filing: **23.02.83**

(54) **Transistor having emitter self-aligned with an extrinsic base contact and method of making it.**

(30) Priority: **07.06.82 US 385740**

(43) Date of publication of application:
**21.12.83 Bulletin 83/51**

(45) Publication of the grant of the patent:
**16.12.87 Bulletin 87/51**

(84) Designated Contracting States:
**DE FR GB**

(56) References cited:
**EP-A-0 051 500**
**US-A-4 157 269**

(73) Proprietor: **International Business Machines Corporation**
**Old Orchard Road**
**Armonk, N.Y. 10504 (US)**

(72) Inventor: **Isaac, Randall Duane**
**3162 Wharton Drive**
**Yorktown Heights New York 10598 (US)**
Inventor: **Ning, Tak Hung**
**1720 Maxwell Drive**
**Yorktown Height New York 10598 (US)**

(74) Representative: **Hobbs, Francis John**
**IBM United Kingdom Limited**
**Intellectual Property Department**
**Hursley Park Winchester**
**Hampshire SO21 2JN (GB)**

Courier Press, Leamington Spa, England.

## Description

This invention relates to bipolar transistors of the type in which the emitter is self-aligned with an extrinsic base contact and to methods of producing such transistors.

Refractory metals or silicides of refractory metals have been used as base contacts to which the emitter of a bipolar transistor is self-aligned. This reduces the extrinsic base area and the series resistance of the extrinsic base of the bipolar transistor. A relevant disclosure is the article by T. H. Ning and H. N. Yu, "Bipolar Transistor Structure with Extended Metal Base Contacts and Diffused or Implanted Emitter," in the IBM Technical Disclosure Bulletin, Vol. 22, No. 5, October 1979, pages 2123—2126. However, this structure does not allow independent doping of the extrinsic and intrinsic base regions.

An alternative process which uses p$^+$ polysilicon as both a base contact and a diffusion source for the extrinsic base is described in US—A—4,157,269. The sheet resistivity of p$^+$ polysilicon is considerably higher ($\infty$100 $\Omega$/square) than that of silicides ($\infty$3 $\Omega$/square).

The conventional polycide stack of doped polysilicon with a layer of silicide on top is difficult to pattern with either reactive ion etching or preferential chemical etchants in the fabrication of bipolar transistor structures where the polycide is etched down to silicon as opposed to the fabrication of FET structures where the polycide is etched down to SiO$_2$.

This invention seeks to provide an improved self-aligned bipolar transistor structure.

A vertical bipolar transistor structure including an emitter region formed above the intrinsic part of the base region of the transistor, a metal silicide layer overlying the extrinsic part of the base region and a polysilicon layer covering the metal silicide layer, the emitter region being aligned with an opening in the polysilicon layer is characterised, according to one aspect of the invention, by the polysilicon layer being doped and contiguous and coextensive with the metal silicide layer whereby the emitter region and intrinsic base region are also aligned with an opening in the metal silicide layer.

According to another aspect of the invention, a method of producing a vertical bipolar transistor structure having an emitter self-aligned with an extrinsic base contact comprises the successive steps of delimiting a transistor area in a semiconductor substrate, depositing in succession over the transistor area a silicide layer, a doped polysilicon layer and a silicon dioxide layer, forming an aperture through the silicon dioxide, the doped polysilicon and the silicide layers, forming an insulating layer over the transistor area and driving in dopant from the polysilicon layer to form an extrinsic base region, removing the insulating layer from the horizontal surfaces of the transistor area but not from the sidewall of the aperture and forming an intrinsic base region and an emitter aligned with the aperture and the extrinsic base region.

How the invention can be carried out will now be described by way of example, with reference to the accompanying drawings, in which:—

Fig. 1 is a diagram of a bipolar transistor structure embodying the invention;

Figs. 2A, 2B, 2C and 2D represent successive stages in a method for producing the bipolar transistor structure of Fig. 1.

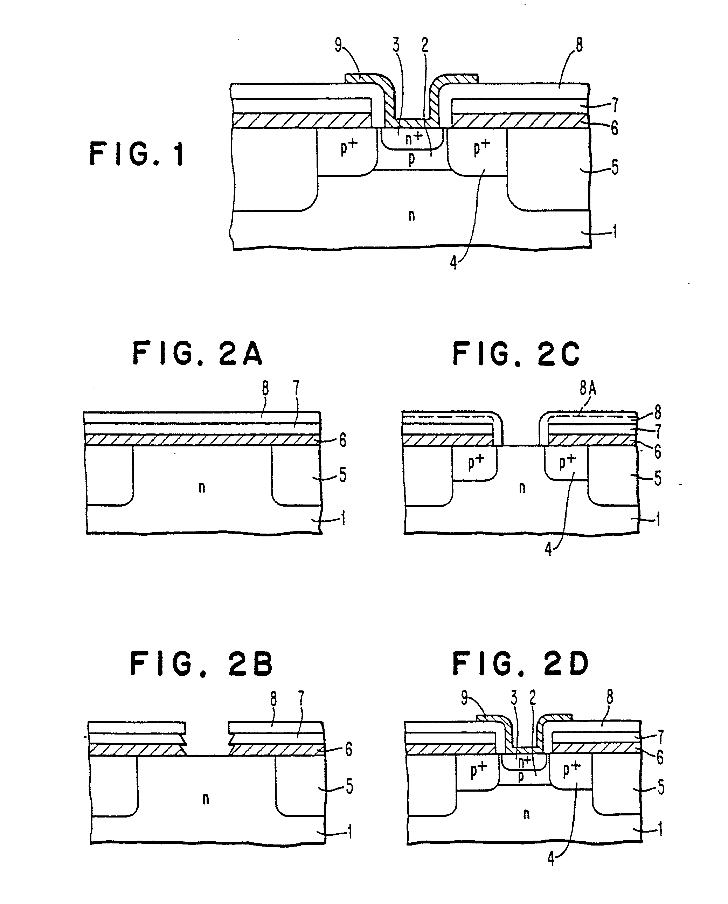

Fig. 1 shows a bipolar transistor having an inverted polycide stack as a low resistivity base contact with which the emitter is self-aligned. The inverted polycide stack, ie a polysilicon layer on top of a silicide layer can serve as a diffusion source and be readily etched down to silicon.

An npn vertical bipolar transistor (Fig. 1) has a collector 1, base 2 and emitter 3. This transistor may one of many in an integrated circuit. An extrinsic base region 4 is formed by diffusing boron impurities from a p$^+$ polysilicon layer 7 through a silicide layer 6. Silicide layer 6 is of a metal silicide, for example tungsten silicide (WSi$_2$). Both the top surface and the vertical edges of p$^+$ polysilicon layer 7 and silicide layer 6 are covered by SiO$_2$ insulating layer 8, which also separates the emitter contact 9 from the base contact layers 6 and 7.

Figs. 2A, 2B, 2C and 2D represent successive stages during the production of the npn bipolar transistor of Fig. 1. An n$^+$ buried layer, epitaxial layer, reach through, isolation etc. are assumed to be in place and are not a part of this invention.

Fig. 2A shows a silicon dioxide layer 5 delimiting a particular transistor area having a collector region 1. Silicide layer 6, p$^+$ polysilicon layer 7, and silicon dioxide layer 8 are deposited in turn over the transistor areas. The inverted polycide stack with the doped polysilicon layer 7 on top of the silicide layer 6 can be readily etched with carbon tetrafluoride plus oxygen (CF$_4$+O$_2$) in a flexible diode system with an etch ratio about 3-5:1 silicide:silicon. This is important in the bipolar structure where the polycide is etched down to silicon. The inverted polycide stack can still be used as a diffusion source, since boron diffuses rapidly through the metal silicide.

Fig. 2B shows the same transistor area as Fig. 2A after a masking and etching sequence to form an aperture through the layers. The aperture determines the position of the emitter and intrinsic base region. The masking and etching sequence comprises the steps of:—

1. forming an emitter opening in a photoresist layer (not shown),

2. reactive ion etching (RIE) oxide layer 8,

3. RIE polysilicon layer 7 (e.g. in CF$_4$+60% O$_2$ plasma),

4. RIE silicide layer 6 (e.g. in CF$_4$+20% O$_2$ plasma),

5. stripping the photo resist.

Fig. 2C shows the transistor area after the steps required to prepare a sidewall insulating layer covering the extrinsic base contact to which the emitter will be selfaligned. These steps are:

1. deposit oxide layer 8A,

2. drive-in boron from the polysilicon layer 7 to dope the extrinsic base region 4,

3. RIE the deposited oxide layer 8A on horizontal surfaces but not the sidewall oxide covering the vertical edges of the extrinsic base contact layer 6, 7.

Fig. 2D illustrates the steps necessary to complete the transistor. These steps are:

1. form emitter 3 and intrinsic base 2 using standard techniques,

2. form emitter contact 9, and

3. form contact (not shown) to the inverted polycide extrinsic base contact layers 6, 7 using standard techniques.

The process sequence described above for fabricating a self-aligned npn bipolar transistor can be readily adapted to fabricate a self-aligned pnp bipolar transistor by using silicon and polysilicon doped with impurities of the opposite polarity.

**Claims**

1. A vertical bipolar transistor structure including an emitter region (3) formed above the intrinsic part (2) of the base region of the transistor, a metal silicide layer (6) overlying the extrinsic part (4) of the base region and a polysilicon layer (7) covering the metal silicide layer, the emitter region being aligned with an opening in the polysilicon layer, the structure being characterised by the polysilicon layer being doped and contiguous and coextensive with the metal silicide layer whereby the emitter region and intrinsic base region are also aligned with an opening in the metal silicide layer.

2. A bipolar transistor structure as claimed in Claim 1, in which the metal silicide is tungsten silicide ($WSi_2$) and the polysilicon layer is doped with boron.

3. A bipolar transistor structure comprising

a. an n-type silicon pedestal (1) forming the collector region limited in area by a circumscribing silicon dioxide region (5);

b. a metal silicide layer (6) covering the transistor area and having an aperture within the area of the pedestal;

c. a $p^+$ polysilicon layer (7) covering said metal silicide layer and having the same aperture;

d. a $p^+$ doped extrinsic base region (4) located underneath said metal silicide layer, and in the region of the pedestal in the area, complementary to the aperture, the polysilicon and metal silicide layers serving as a contact to the extrinsic base region;

e. an insulating layer (8) covering the surface of said $p^+$ polysilicon layer and the edges of said $p^+$ polysilicon layer and said metal silicide layer at the apertures;

f. a p-type intrinsic base region (2) in the region of the pedestal defined by and aligned with the aperture and an $n^+$ doped emitter region (3) above the said intrinsic base region; and

g. an emitter contact (9) covering said emitter region and insulated from said $p^+$ polysilicon layer and from the edges of said $p^+$ polysilicon layer and said metal silicide layer at the aperture by said insulating layer.

4. A method of producing a vertical bipolar transistor structure having an emitter (3) self-aligned with an extrinsic base contact (6, 7) comprising the successive steps of delimiting a transistor area in a semiconductor substrate (1), depositing in succession over the transistor area a silicide layer (6), a doped polysilicon layer (7) and a silicon dioxide layer (8), forming an aperture through the silicon dioxide, the doped polysilicon and the silicide layers, forming an insulating layer (8a) over the transistor area and driving in dopant from the polysilicon layer to form an extrinsic base region (4), removing the insulating layer from the base of the aperture but not from the sidewall of the aperture and forming an intrinsic base region (2) and an emitter (3) aligned with the aperture and the extrinsic base region.

**Patentansprüche**

1. Vertikaler bipolarer Transistoraufbau mit einem über dem eigentlichen Teil (2) des Basisbereichs des Transistors ausgebildeten Emitterbereich (3), einer über dem äußeren Teil (4) des Basisbereichs liegenden Metallsilizidschicht (6) und einer die Metallsilizidschicht abdeckenden Polysiliziumschicht (7), wobei der Emitterbereich auf eine Öffnung in der Polysiliziumschicht ausgerichtet ist, wobei der Aufbau dadurch gekennzeichnet ist, daß die Polysiliziumschicht dotiert und angrenzend an die und sich gemeinsam erstreckend mit der Metallsilizidschicht ist, wodurch der Emitterbereich und der eigentliche Basisbereich ebenfalls auf eine Öffnung in der Metallsilizidschicht ausgerichtet sind.

2. Bipolarer Transistoraufbau nach Anspruch 1, bei welchem das Metallsilizid, Wolframsilizid ($WSi_2$) und die Polysiliziumschicht mit Bor dotiert ist.

3. Bipolarer Transistoraufbau mit

a) einem n-Siliziumsockel (1), welcher den Kollektorbereich bildet, welcher gebietsmäßig durch einen umschließenden Siliziumdioxidbereich (5) begrenzt ist;

b) einer Metallsilizidschicht (6), welche das Transistorgebiet abdeckt und eine Öffnung innerhalb des Gebiets des Sockels aufweist;

c) einer $p^+$-Polysiliziumschicht (7), welche die Metallsilizidschicht abdeckt und die gleiche Öffnung aufweist;

d) einem $p^+$-dotierten äußeren Basisbereich (4), welcher unter der Metallsilizidschicht und im Bereich des Sockels in dem Gebiet komplementär zur Öffnung angeordnet ist, wobei die Polysilizium- und die Metallsilizidschicht als ein Kontakt zum äußeren Basisbereich dienen;

e) einer isolierenden Schicht (8), welche die Oberfläche der $p^+$-Polysiliziumschicht und die Ränder der $p^+$-Polysiliziumschicht und der Metallsiliziumschicht und der Metallsilizidschicht

an den Öffnungen abdeckt;

f) einem p eigentlichen Basisbereich (2) im Bereich des Sockels, welcher durch die Öffnung definiert ist und auf die Öffnung und einen $n^+$-dotierten Emitterbereich (3) über dem eigentlichen Basisbereich ausgerichtet ist; und

g) einem Emitterkontakt (9), welcher den Emitterbereich abdeckt und gegenüber der $p^+$-Polysiliziumschicht und den Rändern der $p^+$-Polysiliziumschicht und der Metallsilizidschicht an der Öffnung durch die isolierende Schicht isoliert ist.

4. Verfahren zur Herstellung eines vertikalen bipolaren Transistoraufbaus mit einem auf einen Kontakt zur äußeren Baisis (6, 7) selbstausgerichteten Emitter (3), mit den aufeinanderfolgenden Verfahrensschritten des Abgrenzens eines Transistorgebiets in einem Halbleitersubstrat (1), des aufeinanderfolgenden Abscheidens einer Silizidschicht (6), einer dotierten Polysiliziumschicht (7) und einer Siliziumdioxidschicht (8) über dem Transistorgebiet, des Ausbildens einer durch die Siliziumdioxid- die dotierte Polysilizium- und die Silizidschicht gehenden Öffnung, des Ausbildens einer isolierenden Schicht (8A) über dem Transistorgebiet und des Eintreibens einer Dotierung aus der Polysiliziumschicht zur Ausbildung eines äußeren Basisbereichs (4), des Entfernens der isolierenden Schicht von der Basis der Öffnung, aber nicht von der Seitenwand der Öffnung und des Ausbildens eines eigentlichen Basisbereichs (2) und eines Emitters (3), die auf die Öffnung und den äußeren Basisbereich ausgerichtet sind.

## Revendications

1. Une structure de transistor bipolaire vertical comprenant une région d'émetteur (3) formée au-dessus de la partie intrinsèque (2) de la région de base du transistor, une couche de siliciure métallique (6) placée sur la partie extrinsèque (4) de la région de base et une couche de polysilicium (7) recouvrant la couche de siliciure métallique, la région d'émetteur étant alignée avec une ouverture formée dans la couche de polysilicium, la structure étant caractérisée en ce que la couche de polysilicium est dopée, contiguë et de même que la couche de siliciure métallique, la région d'émetteur et la région de base intrinsèque étant également alignées avec une ouverture existant dans la couche de siliciure métallique.

2. Une structure de transistor bipolaire telle que revendiquée dans la revendication 1, dans laquelle le siliciure métallique est du siliciure de tungstène ($WSi_2$) et la couche de polysilicium est dopée avec du bore.

3. Une structure de transistor bipolaire comprenant:

a. un substrat (1) en silicium de type-n formant la région de collecteur limitée en étendue par une région périphérique de dioxyde de silicium (5);

b. une couche de siliciure métallique (6) recouvrant la zone de transistor et comportant une ouverture formée à l'intérieur de la zone du substrat;

c. une couche de polysilium $p^+$ (7) recouvrant ladite couche de siliciure métallique et comportant la même ouverture;

d. une région de base extrinsèque dopée $p^+$ (4) placée en dessous de ladite couche de siliciure métallique, et dans la region du substrat dans la zone, complémentaire de l'ouverture, les couches de polysilicium et de siliciure métallique servant de contact pour la région de base extrinsèque;

e. une couche isolante (8) recouvrant la surface de ladite couche de polysilicium $p^+$ et les bords de ladite couche de polysilicium $p^+$ ainsi que ladite couche de siliciure métallique dans les ouvertures;

f. une région de base intrinsèque de type-p (2) placée dans la zone du substrat qui est définie par et alignée avec l'ouverture et une région d'émetteur dopée $n^+$ (3) au-dessus de ladite région de base intrinsèque; et

g. un contact d'émetteur (9) recouvrant ladite région d'émetteur et isolé de ladite couche de polysilicium $p^+$, des bords de ladite couche de polysilicium $p^+$ et de ladite couche de siliciure métallique dans l'ouverture au moyen de ladite couche isolante.

4. Un procédé de production d'une structure de transistor bipolaire vertical comportant un émetteur (3) auto-aligné avec un contact de base extrinsèque (6, 7), comprenant les étapes successives consistant à délimiter une zone de transistor dans un substrat semiconducteur (1), à déposer successivement sur la zone de transistor une couche de siliciure (6), une couche de polysilicium dopé (7) et une couche de dioxyde de silicium (8), à former une ouverture au travers des couches de dioxyde de silicium, de polysilicium dopé et de siliciure, à former une couche isolante (8A) sur la zone de transistor et à introduire un dopant à partir de la couche de polysilicium pour former une région de base extrinsèque (4), à enlever la couche isolante de la base de l'ouverture mais non de la paroi latérale de l'ouverture et à former une région de base intrinsèque (2) et un émetteur (3) aligné avec l'ouverture et la région de base extrinsèque.

**FIG. 1**

**FIG. 2A**

**FIG. 2C**

**FIG. 2B**

**FIG. 2D**